# EUROPEAN PATENT SPECIFICATION

(11) **EP 2 398 148 B1**
(45) Date of publication and mention of the grant of the patent: **16.01.2013**
(21) Application number: 10305659.4
(22) Date of filing: 21.06.2010
(51) Int. Cl.: H03M 3/04, H03F 3/19, H04L 25/49, H04L 27/36

(54) **Rf signal generation device with configurable sigma-delta modulator and pulse-width modulator for output frequency band selection, and associated methods**
HF-Signalerzeugungsvorrichtung mit konfigurierbarem Sigma-Deltamodulator und Pulsweitenmodulator zur Ausgangsfrequenzbandauswahl sowie zugehörige Verfahren
Dispositif de génération de signal RF avec un modulateur sigma-delta et un modulateur de largeur d'impulsion pour la sélection de la bande de fréquence de sortie et procédés apparentés

(43) Date of publication of application: 21.12.2011
(73) Proprietor: Alcatel Lucent, 75007 Paris (FR)
(72) Inventor: Dartois, Luc, 91620, Nozay (FR)
(74) Representative: Therias, Philippe

(56) References cited:
- EP-A1- 2 330 734
- US-A1- 2007 176 810
- US-B1- 7 504 976

## Description

The present invention relates to radio frequency (RF) signal generation devices comprising a sigma-delta modulator and a pulse-width modulator and to associated methods.

The Applicant has recently proposed to combine a sigma-delta modulator (SDM) and a pulse-width modulator (PWM) into a RF signal generation device (for instance a class S power amplifier) to improve digital signal processing (for instance before amplification). More precisely, this RF signal generation device comprises a signal processing circuit for processing an input digital signal (possibly of the complex type), and a pulse-width modulator for producing an analog RF signal, possibly followed by a power amplifier component for amplifying the analog RF signal. The signal processing circuit comprises a digital sigma-delta modulator for modulating the input digital signal into a modulated multi bits digital signal, and an up-sampler and up-converter means for up-sampling and up-converting the modulated multi bits digital signal from a base frequency band to a radio frequency (RF) band. The pulse-width modulator is arranged for transforming the modulated, up-sampled and up-converted multi bits digital signal into an analog RF signal (for instance to be transmitted and/or amplified). Such a RF signal generation device is notably described in the European patent application EP 09290880.5 which has been published as EP 2 330 734 A1.

This type of RF signal generation device offers very good results as long as it is used for producing analog RF signals in a chosen frequency band. More precisely, due to constraints in digital baseband to RF up-samplers but also in the input and output signal frequencies of both SDM and PWM (for stability purpose), these RF signal generation devices are natively suited for a chosen signal sampling rate and a given sigma-delta bandwidth and therefore they are suited for a chosen RF carrier subband and a chosen rate.

So the object of this invention is to allow RF signal generation devices, comprising a sigma-delta modulator and a pulse-width modulator, to be configurable, while using the functionalities of the existing SDM and PWM modules, in order to be capable of producing, on demand, high speed analog RF signals belonging to different output frequency bands while still optimizing the key performances of signal useful bandwidth and signal to noise ratio.

For this purpose, the invention proposes a RF signal generation device comprising:
- a digital sigma-delta modulator arranged for modulating a digital signal to output a modulated digital signal of m quantization bits,
- a transform means arranged for up-sampling and up-converting this modulated multi bits digital signal from a base frequency band to a radio frequency band at a working sampling frequency,
- a pulse-width modulator arranged for transforming this modulated, up-sampled and up-converted digital signal, at this working sampling frequency and by means of n states (with n = 2^{m}), into an analog RF signal comprised into an output frequency band, and
- a clock means arranged for defining the working sampling frequency of the preceding means.

This RF generation device is characterized in that its clock means, digital sigma-delta modulator and pulse-width modulator are configurable by means of control commands in order its working sampling frequency varies in an opposite manner to the number m of quantization bits and number n of (possible) states as a function of a chosen output frequency band.

The RF signal generation device according to the invention may include additional characteristics considered separately or combined, and notably:
- its clock means may be configurable in order to define a chosen working sampling frequency depending on a received control command, its digital sigma-delta modulator may be configurable in order to output modulated digital signals defined by a chosen number m of quantization bits depending on a received control command, and its pulse-width modulator may be configurable in order to transform a modulated, up-sampled and up-converted digital signal, at the chosen working sampling frequency and by means of a chosen number n of states depending on a received control command, into an analog RF signal comprised into the chosen output frequency band;
- the output frequency band may be smaller than or equal to a maximal output frequency band which is associated to a minimal number m of quantization bits, a minimal number n of states and a maximal working sampling frequency;
   ➢ the maximal output frequency band may be, for instance, centered on a frequency which is equal to 2.7 GHz, the minimal number m of quantization bits may be equal to 3, the minimal number n of states may be equal to 8, and the maximal working sampling frequency may be equal to 10.8 GHz. In this case, the pulse-width modulator works with a main clock signal at 10.8*8 = 86.4 GHz;
- its transform means may be arranged for up-sampling the base band modulated multi bits digital signal two times to elaborate the digital RF samples of the modulated, up-sampled and up-converted digital signal;
- it may further comprise up-sampling means arranged for up-sampling a received input digital signal ten times to produce the digital signal that must be modulated by its digital sigma-delta modulator;
- its clock means may comprise a master oscillator arranged for producing a main clock signal at a main frequency, and a configurable divider means arranged for dividing this main frequency of the clock signal by a number k (with k ≥2^{m}) depending on a control command in order to define the chosen working sampling frequency;
   ➢ the master oscillator may be configurable in order to produce a main clock signal at a chosen main frequency depending on a control command;
      • it may further comprise a configurable fractional up-sampling means arranged for multiplying the sampling frequency of a primary digital signal by a chosen fractional factor depending on a control command in order to produce the input digital signal at a rate compatible with the sigma-delta modulator and pulse-width modulator clock rates;
      o it may further comprise a configurable digital auxiliary oscillator arranged for producing an auxiliary complex sine wave signal having a chosen auxiliary frequency depending on a control command, and a combining means arranged for combining the auxiliary signal with a raw digital signal in order to produce a primary digital signal that is well adapted to the chosen configuration of its digital sigma-delta modulator so that the input digital signal of the sigma-delta modulator falls inside its noise free band.

The invention also proposes a power amplifier comprising a radio frequency signal generation device such as the one above introduced and a power amplification means arranged for amplifying the analog radio frequency signals produced by the digital radio frequency signal generation device in order to produce amplified analog signals.

The invention also proposes a RF signal generation method comprising the steps of:
i) modulating a digital signal by means of a digital sigma-delta modulator to output a modulated digital signal of m quantization bits, and up-sampling and up-converting this modulated multi bits digital signal from a base frequency band to a radio frequency band at a working sampling frequency defined by a clock means, and
ii) transforming this modulated, up-sampled and up-converted digital signal, by means of a pulse-width modulator and at the working sampling frequency and by means of n states, into an analog RF signal comprised into an output frequency band.

This method is characterized in that, each time one wants to use a chosen output frequency band, one configures the clock means, digital sigma-delta modulator and pulse-width modulator by means of control commands in order the working sampling frequency varies in an opposite manner to the number m of quantization bits and number n of states as a function of this chosen output frequency band.

The invention also proposes a method for transmitting analog radio frequency signals to a remote equipment (for instance over an optical fibre), in which the analog radio frequency signals are produced either by means of a radio frequency signal generation device such as the one above introduced, or by means of a power amplifier such as the one above introduced, or else by means of a radio frequency signal generation method such as the one above introduced.

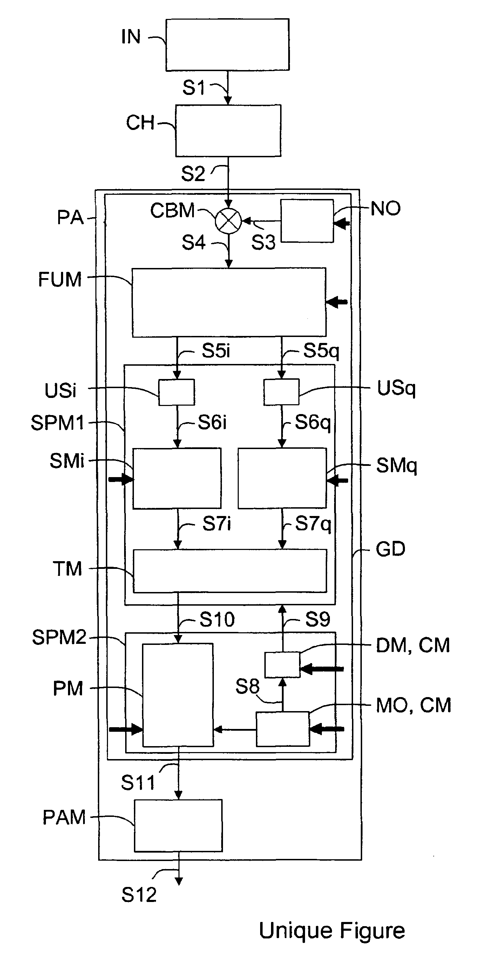

Other features and advantages of the invention will become apparent on examining the detailed specifications hereafter and the appended drawing, wherein the unique figure schematically and functionally illustrates a part of a transmission chain comprising an example of embodiment of a power amplifier according to the invention.

The appended drawing may serve not only to complete the invention, but also to contribute to its definition, if need be.

The invention aims, notably, at providing a RF signal generation device GD which can be configured in order to be capable of producing, on demand, analog RF signals that belong to different frequency bands while optimizing the use of the technology and performances of the sigma-delta modulator and pulse-width modulator they comprise to improve in each output frequency band the useful signal bandwidth and the signal to noise ratio.

In the following description, it will be considered, as example, that the RF signal generation device GD belongs to a class S power amplifier PA, which belongs itself to a transmission chain of a communication equipment, such as a base station of a communication network. But, the invention is not limited to this application. Indeed a RF signal generation device GD may be only used for producing 2 states high speed analog RF signals that are ready to be transmitted without distortion over an optical fibre by means of electro-optical and opto-electronic modulators for usage in remote radio systems or equipments. It may be also used for producing analog RF signals that can be bandpass filtered to generate a high quality analog low level RF signal for different applications, and notably in transmission chains or for amplifications which are not of the class S type.

As illustrated in the unique figure a transmission chain may comprise an interface IN, for instance of the CPRI type (3GPP Common Public Radio Interface), a channelizer CH and a (class S) power amplifier PA.

The interface IN is arranged for outputting raw (or baseband) digital signals S1 into several channels. It is recalled that in the case of a CPRI interface IN, the channels are named containers and contain each digital samples that represent in baseband one RF carrier to be transmitted. The channelizer CH is arranged for selecting and combining amongst the raw digital signals S1 those (S2) which belong to one or more selected channels (or containers) in order to output them with the right output sample rate, usually a small integer multiple of the interface channels.

The power amplifier PA, according to the invention, is arranged for amplifying the raw digital signals S2 outputted by the channelizer CH, or primary digital signals S4 derived from these raw digital signals S2 (as will be explained below), in order to output amplified radio frequency (RF) signals S12 belonging to a chosen output frequency band (and here ready to be radio transmitted).

As illustrated, this power amplifier PA comprises a RF signal generation device GD, which may comprise a first signal processing module SPM1 and a second signal processing module SPM2, and a power amplification module PAM.

The first signal processing module SPM1 of the RF signal generation device GD comprises at least a digital sigma-delta modulator SMi, SMq, and a transform means TM. Preferably and as illustrated, the first signal processing module SPM1 may comprise also an up-sampling means USi, USq that is arranged for up-sampling a received input digital signal S5i, S5q to produce digital signals S6i, S6q that must be modulated by the digital sigma-delta modulator SMi, SMq.

In the following description it will be considered, as an example, that the received input digital signals S5i, S5q are complex, belong to a baseband and are build from primary digital signals S4 that are derived from the raw digital signals S2 outputted by the channelizer CH.

It is recalled that a complex signal S5 comprises a real part S5i and an imaginary part S5q that are bound together by the relation: S5 = S5i + j*S5q, with j*j = -1. The real part S5i is an in-phase signal, while the imaginary part S5q is a quadrature signal.

It results from the above cited consideration that the possible up-sampling means comprises a first up-sampler USi arranged for up-sampling the real part S5i of the received input digital signals (here ten times) to produce a real pre up-sampled digital signal S6i, and a second up-sampler USq arranged for up-sampling the imaginary part S5q of the received input digital signals (here ten times) to produce an imaginary pre up-sampled digital signal S6q, and that the digital sigma-delta modulator (SDM) comprises a first SDM sub module SMi arranged for modulating the real pre up-sampled digital signal S6i to produce a real modulated digital signal S7i of m quantization bits, and a second SDM sub module SMq arranged for modulating the imaginary pre up-sampled digital signal S6i to produce an imaginary modulated digital signal S7q of m quantization bits. But this is only a non limiting example, and in a variant the received input digital signals could be real signals.

If S6 = S6i + j*S6q, then, as the sigma-delta modulation (SDM) in the baseband has a linear behaviour, S7 = SDM(S6i) + j*SDM(S6q) = S7i + j*S7q. This means that the first SMi and second SMq SDM sub modules may run independently on S6i and S6q. Thus, the modulated multi bits digital signal S7 has still the same frequency than the pre up-sampled digital signal S6.

For instance, the modulated multi bits digital signals S7 are quantified on at least 3 quantization bits. The modulated multi bits digital signals S7 must be transposed digitally into a radio frequency band. This is done by the transform means TM.

More precisely, the transform means TM is arranged for up-sampling and up-converting the modulated multi bits digital signals S7i and S7q (outputted by the first SMi and second SMq SDM sub modules) from a base frequency band (or baseband) to a radio frequency (or RF) band at a chosen working sampling frequency WSF, in order to output a modulated, up-sampled and up-converted digital signal S10.

As illustrated, the chosen working sampling frequency WSF is defined by a clock means CM that may belong to the second signal processing module SPM2 of the RF signal generation device GD and may be of the tree type, for instance. This clock means CM comprises at least a master oscillator MO which is arranged for producing a main clock signal at a main frequency MF. As illustrated the clock means may further comprise a divider means DM which is arranged for dividing the main frequency MF of the clock signal (outputted by the master oscillator MO) by a number k (with k ≥2^{m}) in order to define the chosen working sampling frequency WSF. For instance, k may be equal to 8 (in this case WSF = MF/8).

For instance, this transform means TM is arranged for up-sampling the modulated multi bits digital signals S7i and S7q two times in order the sampling rate of the outputted modulated, up-sampled and up-converted digital signal S10 is four times the wanted radio frequency carrier of the amplified signal S12 that is finally outputted by the power amplification means PAM. These very simple up-sampling and up-conversion can be performed by means of samples replication with or without sign changes. Thereby, the transposition carrier is a simple periodic sequence of complex values in the four quadrants so that digital transposition from baseband to RF becomes a simple selection of the real or imaginary value with alternate sign change of the modulated multi bits digital signals S7i and S7q that have been up-sampled.

Due to this example of up-sampling by 2, using a repetition of two consecutive S7 samples, the spectrum of the transform means TM is then a low pass sinc like function with a spectral maximum at 0 Hz and a spectral null at the wanted radio frequency carrier, for example 2.5 GHz. Thus, S10 is a sequence of the type: C=S7i(p) -S7q(p) -S7i(p+1) -S7q(p+1) ..., wherein p is the number of the sample with which transposing is started.

Because the modulated multi bits digital signals S7 consist of two parts S7i and S7q in this example, two samples of the modulated, up-sampled and up-converted digital signal S10 are derived from one complex sample of the modulated multi bits digital signals S7 using the above mentioned transposition signal represented by samples in the four quadrants. Therefore, a 2.5 GHz amplified signal S12 is sampled at 10 GHz.

It is important to note that short sample sequences of the modulated multi bits digital signal S7 may be stored in a dedicated RAM memory (not illustrated) in order to be used for further signal processing steps for predistortion, for instance.

It is also important to note that the modulated, up-sampled and up-converted digital signal S10 consists of a plurality of Dirac digital samples (or pulses) in different states which correspond respectively to different energies of the Dirac digital pulses (2^{m} states for m bits samples).

The second signal processing module SPM2 of the RF signal generation device GD comprises a pulse-width-modulator (PWM) PM which is arranged for transforming the modulated, up-sampled and up-converted digital signal S10 into an analog dual states signal S11 comprised into the chosen output frequency band (or RF carrier band). This transformation is carried out at the chosen working sampling frequency WSF and by means of n possible states. In other words, the pulse-width-modulator (PWM) PM modulates the Dirac digital samples (or pulses) into rectangular binary pulses with different widths (here compatible with class S switch mode amplifier (in the described example)). In the case where the minimal number n of states that can take the pulse-width-modulator PM is equal to 8, there is one pulse width of 0 and 7 non-null pulse widths. The 7 non-null pulse widths generated by the pulse-width-modulator PM have each a given spectrum. It is recalled that n = 2^{m}.

The energy and the spectrum of the Dirac digital samples (or pulses) defining the modulated, up-sampled and up-converted digital signal S10, which have mathematically each a flat spectrum, are reproduced by the pulse-width-modulator PM with some known attenuation for each pulse width according to its known spectral response at the used carrier frequency.

The pulse widths are defined from the main clock signal produced by the clock means CM, and more precisely from the clock signal having the chosen main frequency MF that is outputted by the master oscillator MO. Still more precisely a single clock period at the output of the master oscillator MO is the minimum width of a non-null pulse. Each width of a non-null pulse must be a multiple of this clock period. Thus, the higher the clock period is the smaller pulses are possible.

As mentioned before and as illustrated, the power amplification module PAM is arranged for amplifying the analog signal S11 (outputted by the pulse-width-modulator PM) in order to output an amplified analog signal S12 (ready to be transmitted).

According to the invention at least the clock means CM, the digital sigma-delta modulator SMi, SMq and the pulse-width modulator PM are configurable by means of control commands (materialized by thick arrows in the unique figure), preferably one for each of them, in order the working sampling frequency WSF could vary (and therefore could be chosen on demand) in an opposite manner to the number m of quantization bits and the number n of (possible) states, as a function of the chosen output frequency band (i.e. the RF carrier band) of the amplified analog signal S12.

In other words, each output frequency band, offered by a power amplifier PA, corresponds to a predetermined triplet of first, second and third parameter values, where the first parameter is the working sampling frequency WSF, the second parameter is the number m of quantization bits (of the digital sigma-delta modulator SMi, SMq), and the third parameter is the number n of (possible) states (of the pulse-width modulator PM). Moreover, when the value of the first parameter (WSF) decreases from its maximum, the values of the second (m) and third (n) parameters increase, and reversely when the value of the first parameter (WSF) increases towards its maximum, the values of the second (m) and third (n) parameters decrease. This allows having an approximately constant signal to noise ratio (or SNR) when the RF carrier is decreased. This allows also a controlled sigma-delta modulator bandwidth and a proper centering control of transmitted signal inside the sigma-delta modulator noise free band.

It is important to understand that when the number m of quantization bits increases, the quantity of information contained into a modulated multi bits digital signal S7 increases and therefore the noise decreases, which allows to enlarge the useful bandwidth.

Each time one adds a quantization bit to the current number m of quantization bits (m→ m+1), one decreases by one octave the current central frequency (i.e. the RF carrier) of the output frequency band. It is important to note that with constant sigma-delta modulator filter parameters there is also a decrease in the same proportions of the sigma-delta modulator noise free bandwidth, which is then partly compensated by the in-band noise floor decrease.

This output frequency band may be smaller than or equal to the maximal output frequency band that is supported by the power amplifier PA and that is associated to a minimal number m of quantization bits, a minimal number n of states and a maximal working sampling frequency WSFₘₐₓ. For instance, the maximal output frequency band may be centered on a maximal central frequency equal to 2.7 GHz, the minimal number m of quantization bits may be equal to 3, the minimal number n of states may be equal to 8, and the maximal working sampling frequency WSFₘₐₓ may be equal to 10.8 GHz.

With these above mentioned maximal and minimal values, if one wants to have a central frequency (i.e. the RF carrier) of the output frequency band equal to 2.5 GHz with a main clock signal at a main frequency MF equal to 80 GHz, and a received input digital signal S5 having a sampling rate equal to 500 MSPS (mega samples per second) with an up-sampling by a factor 10 into the up-sampling means USi, USq, then i) the value k of the divider means DM must be configured to 8 (k = 8) to offer a chosen working sampling frequency WSF equal to 10 GHz (80/8), ii) the number m of quantization bits must be configured to 3, and iii) the number n of possible states of the pulse-width modulator PM must be configured to 8. Now, if one wants to have a central frequency (i.e. the RF carrier) of the output frequency band equal to 1.25 GHz with a main clock signal at a main frequency MF equal to 80 GHz and a received input digital signal S5 having a sampling rate equal to 250 MSPS (mega samples per second) with an up-sampling by a factor 10 into the up-sampling means USi, USq, then i) the value k of the divider means DM must be configured to 16 (k = 16) to offer a chosen working sampling frequency WSF equal to 5 GHz (80/16), ii) the number m of quantization bits must be configured to 4, and iii) the number n of possible states of the pulse-width modulator PM must be configured to 16. And, if one wants to have a central frequency (i.e. the RF carrier) of the output frequency band equal to 625 MHz with a main clock signal at a main frequency MF equal to 80 GHz and a received input digital signal S5 having a sampling rate equal to 125 MSPS with an up-sampling by a factor 10 into the up-sampling means USi, USq, then i) the value k of the divider means DM must be configured to 32 (k = 32) to offer a chosen working sampling frequency WSF equal to 2.5 GHz (80/32), ii) the number m of quantization bits must be configured to 5, and iii) the number n of possible states of the pulse-width modulator PM must be configured to 32.

As illustrated in the example of the unique figure, the RF signal generation device GD may comprise other complementary means to allow a fine and precise positioning of the central frequency of the chosen output frequency band.

For instance, the master oscillator MO may be configurable in order to be capable of producing a main clock signal at a chosen main frequency MF which depends on a control command. To this effect, the master oscillator MO may, for instance, comprise a voltage control oscillator (or VCO) within a PLL in order to be locked to a clean reference, as at very high frequency it is important to minimize the phase noise for proper pulses generation.

When the RF signal generation device GD comprises such a configurable master oscillator MO, it is advantageous, as illustrated, that it further comprises a configurable fractional up-sampling means FUM that is arranged for multiplying the sampling frequency of a primary digital signal S4 by a chosen fractional factor which depends on a control command, in order to produce the input digital signal S5 (here S5i and S5q).

The fractional factor (or interpolation), that is applied to the primary digital signal S4, is chosen in order to minimize the sets and lengths of the polyphase filters that are comprised into the fractional up-sampling means FUM and arranged for defining the chosen fractional factor.

It is still more advantageous, as illustrated, that the RF signal generation device GD further comprises a configurable digital auxiliary oscillator NO and a combining means CBM. The digital auxiliary oscillator NO is arranged for producing an auxiliary complex sine wave signal S3 having a chosen auxiliary frequency AF which depends on a control command. To this effect, the digital auxiliary oscillator NO may be a numerical control oscillator (or NCO - i.e. a digital VCO), for instance.

The combining means CBM is arranged for combining the auxiliary signal S3 (produced by the digital auxiliary oscillator NO) with the raw digital signal S2 in order to produce the primary digital signal S4 that is well adapted to the chosen configuration of the digital sigma-delta modulator SMi, SMq and which feeds the fractional up-sampling means FUM.

The input rate of the digital sigma-delta modulator SMi, SMq (i.e. of signal S6) needs to remain an integer subharmonic of the sampling rate of the digital sigma-delta modulator SMi, SMq and larger than the noise transfer function (or NTF) band of the digital sigma-delta modulator SMi, SMq to keep the SDM loop stability.

It is important to note that the chosen auxiliary frequency AF may be positive or negative (it depends on a control command).

It is important to note that in the illustrated example the configurable digital auxiliary oscillator NO and the combining means are part of the RF signal generation device GD and located upstream the fractional up-sampling means FUM. This allows a lower consumption and a lower clock speed. But, they could be located just after the fractional up-sampling means FUM (downstream), for instance.

For instance, if one wants to have a central frequency (i.e. the RF carrier) of the output frequency band equal exactly to 2.5 GHz with a raw digital signal S2 having a sampling rate equal to 61.44 MSPS (case of UMTS or LTE standards) and with an up-sampling by a factor 10 into the up-sampling means USi, USq, then i) an auxiliary signal S3 having an auxiliary frequency AF equal to -8.8 MHz must be combined with the raw digital signal S2, ii) the fractional factor must be configured to 49/6 to produce a received input digital signal S5 having a sampling rate equal to 501.76 MSPS, iii) the main frequency MF (produced by the master oscillator MO) must be configured to 80.2816 GHz (by construction MF = 160*SR(S5) = 160*0.50176 = 80.2816 GHz, with 160 = 10*2*8), iv) the value k of the divider means DM must be configured to 8 (k = 8) to offer a chosen working sampling frequency WSF equal to 10.0352 GHz (80.2816/8, but also 0.50176*10*2 = 10.0352 GHz), v) the number m of quantization bits must be configured to 3, and vi) the number n of possible states of the pulse-width modulator PM must be configured to 8. Now, if one wants to have a central frequency (i.e. the RF carrier) of the output frequency band equal exactly to 2.1 GHz with a raw digital signal S2 having a sampling rate equal to 61.44 MSPS and with an up-sampling by a factor 10 into the up-sampling means USi, USq, then i) an auxiliary signal S3 having an auxiliary frequency AF equal to +7.2 MHz must be combined with the raw digital signal S2, ii) the fractional factor must be configured to 109/16 to produce a received input digital signal S5 having a sampling rate (SR(S5)) equal to 418.56 MSPS, iii) the main frequency MF produced by the master oscillator MO must be configured to 66.9696 GHz (by construction MF = 160*SR(S5) = 160*0.41856 = 66.9696 GHz), iv) the value k of the divider means DM must be configured to 8 (k = 8) to offer a chosen working sampling frequency WSF equal to 8.3712 GHz (66.9696/8, but also 0.41856*10*2 = 10.0352 GHz), vi) the number m of quantization bits must be configured to 3, and iv) the number n of possible states of the pulse-width modulator PM must be configured to 8.

A RF signal generation device GD, according to the invention, may be made of one or several ASICS and/or one or several integrated circuits, for instance of the FPGA type ("Field Programmable Gate Array").

Moreover, it is important to note that the RF signal generation device GD, according to the invention, may comprise complementary, but not mandatory, means that are described in the above cited European patent application EP 09290880.5.

The invention can also be considered in terms of a method for generating analog RF signals that may be implemented by means of a power amplifier PA such as the one above described with reference to the unique figure. Therefore, only its main characteristics will be mentioned hereafter.

The method according to the invention comprises the steps of:
i) modulating a digital signal S6 by means of a digital sigma-delta modulator SMi, SMq to output a modulated multi bits digital signal S7 of m quantization bits, and up-sampling this modulated multi bits digital signal from S7 a base frequency band to a radio frequency band at a working sampling frequency WSF defined by a clock means CM, and
ii) transforming the modulated, up-sampled and up-converted digital signal S10, by means of a pulse-width modulator PM and at this working sampling frequency WSF and by means of n states, into an analog radio frequency signal S11 comprised into an output frequency band, and each time one wants to use a chosen output frequency band, one configures the clock means CM, digital sigma-delta modulator SMi, SMq and pulse-width modulator PM by means of control commands in order the working sampling frequency WSF varies in an opposite manner to the number m of quantization bits and number n of states as a function of the chosen output frequency band.

The invention offers several advantages amongst which:
- a coverage of one or several (at least two) RF octaves in a quasi continuous way for all cellular network band from few 100 MHz to 2.6 GHz and for approximately 20 to 150 MHz signal bandwidth in different frequency bands,
- at least an upholding (and possibly an improvement) of the signal to noise ratio (SNR) even when the sigma-delta sampling rate is decreased for lower frequency bands,
- a production of a single configurable RF signal generation device that can be used for many applications.

The invention is not limited to the embodiments of RF signal generation device GD, power amplifier, transmission chain and RF signal generation method described above, only as examples, but it encompasses all alternative embodiments which may be considered by one skilled in the art within the scope of the claims hereafter.

## Claims

1. Radio frequency signal generation device (GD) comprising i) a digital sigma-delta modulator (SMi,SMq) arranged for modulating a digital signal to output a modulated digital signal of m quantization bits, ii) a transform means (TM) arranged for up-sampling and up-converting said modulated multi bits digital signal from a base frequency band to a radio frequency band at a working sampling frequency, iii) a pulse-width modulator (PM) arranged for transforming said modulated, up-sampled and up-converted digital signal, at said working sampling frequency and by means of n states, into an analog radio frequency signal comprised into an output frequency band, and iv) a clock means (CM) arranged for defining said working sampling frequency, **characterized in that** said clock means (CM), said digital sigma-delta modulator (SMi, SMq) and said pulse-width modulator (PM) are configurable by means of control commands in order that said working sampling frequency varies in an opposite manner to said number m of quantization bits and said number n of states as a function of a chosen output frequency band.

2. Device according to claim 1, **characterized in that** said clock means (CM, DM) is configurable in order to define a chosen working sampling frequency depending on a received control command, **in that** said digital sigma-delta modulator (SMi, SMq) is configurable in order to output modulated digital signals defined by a chosen number m of quantization bits depending on a received control command, and **in that** said pulse-width modulator (PM) is configurable in order to transform said modulated, up-sampled and up-converted digital signal, at said chosen working sampling frequency and by means of a chosen number n of states depending on a received control command, into an analog RF signal comprised into said chosen output frequency band.

3. Device according to one of claims 1 and 2, **characterized in that** said output frequency band is smaller than or equal to a maximal output frequency band associated to a minimal number m of quantization bits, a minimal number n of states and a maximal working sampling frequency.

4. Device according to claim 3, **characterized in that** said maximal output frequency band is centered on a frequency equal to 2.7 GHz, said minimal number m of quantization bits is equal to 3, said minimal number n of states is equal to 8, and said maximal working sampling frequency is equal to 10.8 GHz.

5. Device according to one of claims 1 to 4, **characterized in that** said transform means (TM) is arranged for up-sampling said base band modulated multi bits digital signal two times to elaborate digital RF samples of said modulated, up-sampled and up-converted digital signal.

6. Device according to one of claims 1 to 5, **characterized in that** it further comprises up-sampling means (USi, USq) arranged for up-sampling a received input digital signal ten times to produce said digital signal to be modulated by said digital sigma-delta modulator (SM).

7. Device according to one of claims 1 to 6, **characterized in that** said clock means (CM) comprises a master oscillator (MO) arranged for producing a main clock signal at a main frequency, and a configurable divider means (DM) arranged for dividing said main frequency of the clock signal by a number k depending on said control command in order to define said chosen working sampling frequency.

8. Device according to claim 7, **characterized in that** said master oscillator (MO) is configurable to produce a main clock signal at a chosen main frequency depending on a control command.

9. Device according to the combination of claims 6 and 8, **characterized in that** it further comprises a configurable fractional up-sampling means (FUM) arranged for multiplying the sampling frequency of a primary digital signal by a chosen fractional factor depending on a control command in order to produce said input digital signal at a rate compatible with said sigma-delta modulator (SMi, SMq) and pulse-width modulator (PM) clock rates.

10. Device according to claim 9, **characterized in that** it further comprises a configurable digital auxiliary oscillator (NO) arranged for producing an auxiliary complex sine wave signal having a chosen auxiliary frequency depending on a control command, and a combining means (CBM) arranged for combining said auxiliary signal with a raw digital signal in order to produce a primary digital signal that is well adapted to the chosen configuration of said digital sigma-delta modulator (SM).

11. Power amplifier (PA), **characterized in that** it comprises a radio frequency signal generation device (GD) according to one of claims 1 to 10 and a power amplification means (PAM) arranged for amplifying the analog radio frequency signals produced by said radio frequency signal generation device (GD) to produce amplified analog signals.

12. Radio frequency signal generation method comprising the steps of i) modulating a digital signal by means of a digital sigma-delta modulator (SMi, SMq) to output a modulated digital signal of m quantization bits, and up-sampling and up-converting said modulated multi bits digital signal from a base frequency band to a radio frequency band at a working sampling frequency defined by a clock means (CM), and ii) transforming said modulated, up-sampled and up-converted digital signal, by means of a pulse-width modulator (PM) and at said working sampling frequency and by means of n states, into an analog radio frequency signal comprised into an output frequency band, **characterized in that**, each time one wants to use a chosen output frequency band, one configures said clock means (CM), said digital sigma-delta modulator (SMi, SMq) and said pulse-width modulator (PM) by means of control commands in order said working sampling frequency varies in an opposite manner to said number m of quantization bits and said number n of states as a function of said chosen output frequency band.

13. Method for transmitting analog radio frequency signals to a remote equipment, **characterized in that** said analog radio frequency signals are produced either by means of a radio frequency signal generation device (GD) according to one of claims 1 to 10, or by means of a power amplifier (PA) according to claim 11, or else by means of a radio frequency signal generation method according to claim 12.

## Patentansprüche

1. Funkfrequenzsignalerzeugungsvorrichtung (GD), umfassend i) einen digitalen Sigma-Delta-Modulator (SMi, SMq), ausgelegt für das Modulieren eines digitalen Signals, um ein moduliertes digitales Signal mit m Quantisierungsbits auszugeben, ii) ein Transformationsmittel (TM), ausgelegt für die Aufwärtsabtastung und die Aufwärtskonvertierung des besagten modulierten digitalen Multibit-Signals von einem Basisfrequenzband in ein Funkfrequenzband mit einer Arbeitsabtastfrequenz, iii) einen Pulsweitenmodulator (PM), ausgelegt für die Transformation des besagten modulierten, aufwärtsabgetasteten und aufwärtskonvertierten digitalen Signals mit der besagten Arbeitsabtastfrequenz und anhand von n Zuständen, in ein in einem Ausgangsfrequenzband enthaltenes analoges Funkfrequenzsignal, und iv) ein Zeitgebermittel (CM), ausgelegt für das Definieren der besagten Arbeitsabtastfrequenz, **dadurch gekennzeichnet, dass** das besagte Zeitgebermittel (CM), der besagte digitale Sigma-Delta-Modulator (SMi, SMq) und der besagte Pulsweitenmodulator (PM) mittels Steuerbefehlen konfigurierbar sind, um zu bewirken, dass die besagte Arbeitsabtastfrequenz in einer zu der besagten Anzahl m von Quantisierungsbits und der besagten Anzahl n von Zuständen umgekehrten Weise in Abhängigkeit von einem gewählten Ausgangsfrequenzband variiert.

2. Vorrichtung nach Anspruch 1, **dadurch gekennzeichnet, dass** das besagte Zeitgebermittel konfigurierbar ist, um eine gewählte Arbeitsabtastfrequenz in Abhängigkeit von einem empfangenen Steuerbefehl zu definieren, dass der besagte digitale Sigma-Delta-Modulator (SMi, SMq) konfigurierbar ist, um durch eine in Abhängigkeit von einem empfangenen Steuerbefehl gewählte Anzahl m von Quantisierungsbits definierte modulierte digitale Signale auszugeben, und dass der besagte Pulsweitenmodulator (PM) konfigurierbar ist, um das besagte modulierte, aufwärtsabgetastete und aufwärtskonvertierte digitale Signal mit der besagten gewählten Abtastfrequenz und anhand einer in Abhängigkeit von einem empfangenen Steuerbefehl gewählten Anzahl n von Zuständen in ein analoges, in dem besagten gewählten Ausgangsfrequenzband enthaltenes analoges RF-Signal zu transformieren.

3. Vorrichtung nach einem der Ansprüche 1 und 2, **dadurch gekennzeichnet, dass** das besagte Ausgangsfrequenzband kleiner als ein maximales oder gleich einem maximalen Ausgangsfrequenzband ist, welches mit einer minimalen Anzahl m von Quantisierungsbits, einer minimalen Anzahl n von Zuständen und einer maximalen Arbeitsabtastfrequenz assoziiert ist.

4. Vorrichtung nach Anspruch 3, **dadurch gekennzeichnet, dass** das besagte maximale Ausgangsfrequenzband auf einer 2.7 GHz entsprechenden Frequenz zentriert ist, wobei die besagte minimale Anzahl von m Quantisierungsbits gleich 3 ist, wobei die besagte minimale Anzahl n von Zuständen gleich 8 ist, und wobei die besagte maximale Arbeitsabtastfrequenz gleich 10.8 GHz ist.

5. Vorrichtung nach einem der Ansprüche 1 bis 4, **dadurch gekennzeichnet, dass** das besagte Transformationsmittel (TM) dazu ausgelegt ist, die besagten modulierten digitalen Basisband-Multibit-Signale zweimal aufwärtsabzutasten, um digitale RF-Abtastwerte des besagten modulierten, digitalen aufwärtsabgetasteten und aufwärtskonvertierten Signals zu erhalten.

6. Vorrichtung nach einem der Ansprüche 1 bis 5, **dadurch gekennzeichnet, dass** sie weiterhin Aufwärtsabtastmittel (USi, USq) umfasst, die für das zehnfache Aufwärtsabtasten eines empfangenen digitalen Eingangssignals ausgelegt sind, um das besagte, von dem besagten digitalen Sigma-Delta-Modulator (SM) zu modulierende digitale Signal zu erzeugen.

7. Vorrichtung nach einem der Ansprüche 1 bis 6, **dadurch gekennzeichnet, dass** das besagte Zeitgebermittel (CM) einen Master-Oszillator (MO), welcher für das Erzeugen eines Haupttaktsignals mit einer Hauptfrequenz ausgelegt ist, und ein konfigurierbares Dividiermittel (DM), welches für das Dividieren der besagten Hauptfrequenz des Taktsignals durch eine Zahl k in Abhängigkeit von dem besagten Steuerbefehl zu dividieren, um die besagte gewählte Arbeitsabtastfrequenz zu definieren, umfasst.

8. Vorrichtung nach Anspruch 7, **dadurch gekennzeichnet, dass** der besagte Master-Oszillator (MO) konfigurierbar ist, um ein Haupttaktsignal mit einer gewählten Hauptfrequenz in Abhängigkeit von einem Steuerbefehl zu erzeugen.

9. Vorrichtung gemäß der Kombination der Ansprüche 6 und 8, **dadurch gekennzeichnet, dass** sie weiterhin ein konfigurierbares Teilaufwärtsabtastmittel (FUM) umfasst, welches für das Multiplizieren der Abtastfrequenz eines primären digitalen Signals mit einem gewählten Bruchfaktor in Abhängigkeit von einem Steuerbefehl ausgelegt ist, um das besagte digitale Eingangssignal mit einer Rate, die mit dem Sigma-Delta-Modulator (SMI, SMq) und den Taktraten des Pulsweitenmodulators (PM) kompatibel ist, zu erzeugen.

10. Vorrichtung nach Anspruch 9, **dadurch gekennzeichnet, dass** sie weiterhin einen konfigurierbaren digitalen Hilfsoszillator (NO), welcher dazu ausgelegt ist, ein komplexes Sinuswellen-Hilfssignal mit einer in Abhängigkeit von einem Steuerbefehl gewählten Hilfsfrequenz zu erzeugen, und ein Kombinationsmittel (CBM), welches für das Kombinieren des besagten Hilfssignals mit einem digitalen Rohsignal ausgelegt ist, um ein primäres digitales Signal zu erzeugen, welches auf die gewählte Konfiguration des besagten digitalen Sigma-Delta-Modulators (SM) abgestimmt ist, umfasst.

11. Leistungsverstärker (PA), **dadurch gekennzeichnet, dass** er eine Funkfrequenzsignalerzeugungsvorrichtung (GD) gemäß einem der Ansprüche 1 bis 10, und ein Leistungsverstärkungsmittel (PAM), welches für die Verstärkung des von der Funkfrequenzsignalerzeugungsvorrichtung (GD) erzeugten analogen Funkfrequenzsignals ausgelegt ist, um verstärkte analoge Signale zu erzeugen, umfasst.

12. Verfahren zur Erzeugung eines Funkfrequenzsignals, die folgenden Schritte umfassend: i) Modulieren eines digitalen Signals anhand eines digitalen Sigma-Delta-Modulators (SMi, SMq), um ein moduliertes digitales Signal mit m Quantisierungsbits auszugeben, und Aufwärtsabtasten und Aufwärtskonvertieren des besagten modulierten digitalen Multibit-Signals von einem Basisfrequenzband in ein Funkfrequenzband mit einer von einem Zeitgebermittel (CM) definierten Arbeitsabtastfrequenz, und ii) Transformieren des besagten modulierten, aufwärtsabgetasteten und aufwärtskonvertierten digitalen Signals anhand eines Pulsweitenmodulators (PM) und mit der besagten Arbeitsabtastfrequenz und anhand von n Zuständen, in ein in einem Ausgangsfrequenzband enthaltenes analoges Funkfrequenzsignal, **dadurch gekennzeichnet, dass** man jedes Mal, wenn man ein gewähltes Ausgangsfrequenzband benutzen möchte, das besagte Zeitgebermittel (CM), den besagten digitalen Sigma-Delta-Modulator (SMi, SMq) und den besagten Pulsweitenmodulator (PM) mittels Steuerbefehlen konfiguriert, um zu bewirken, dass die besagte Arbeitsabtastfrequenz in einer zu der besagten Anzahl m von Quantisierungsbits und der besagten Anzahl n von Zuständen umgekehrten Weise in Abhängigkeit von einem gewählten Ausgangsfrequenzband variiert.

13. Verfahren zur Übertragung von analogen Funkfrequenzsignalen an ein entferntes Gerät, **dadurch gekennzeichnet, dass** die besagten analogen Funkfrequenzsignale entweder anhand einer Funkfrequenzsignalerzeugungsvorrichtung (GD) gemäß einem der Ansprüche 1 bis 10, oder anhand eines Leistungsverstärkers (PA) gemäß Anspruch 11, oder auch mittels eines Funkfrequenzsignaler-zeugungsverfahrens gemäß Anspruch 12 erzeugt werden.

## Revendications

1. Dispositif de génération de signaux de radiofréquence (GD) comprenant i) un modulateur sigma-delta numérique (SMi, SMq) conçu pour moduler un signal numérique pour délivrer en sortie un signal numérique modulé de m bits de quantification, ii) un moyen de transformation (TM) conçu pour suréchantillonner et convertir vers le haut ledit signal numérique multi-bits modulé d'une bande de fréquences de base à une bande de radiofréquence à une fréquence d'échantillonnage de travail, iii) un modulateur d'impulsions en largeur (PM) conçu pour transformer ledit signal numérique modulé, suréchantillonné et converti vers le haut, à ladite fréquence d'échantillonnage de travail et au moyen de n états, en un signal de radiofréquence analogique contenu dans une bande de fréquences de sortie, et iv) un moyen d'horloge (CM) conçu pour définir ladite fréquence d'échantillonnage de travail, **caractérisé en ce que** ledit moyen d'horloge (CM), ledit modulateur sigma-delta numérique (SMi, SMq) et ledit modulateur d'impulsions en largeur (PM) peuvent être configurés au moyen de commandes de contrôle afin que ladite fréquence d'échantillonnage de travail varie d'une manière opposée audit nombre m de bits de quantification et audit nombre n d'états en fonction d'une bande de fréquences de sortie choisie.

2. Dispositif selon la revendication 1, **caractérisé en ce que** ledit moyen d'horloge (CM, DM) peut être configuré afin de définir une fréquence d'échantillonnage de travail choisie en fonction d'une commande de contrôle reçue, **en ce que** ledit modulateur sigma-delta numérique (SMi, SMq) peut être configuré afin de délivrer en sortie des signaux numériques modulés définis par un nombre m choisi de bits de quantification en fonction d'une commande de contrôle reçue, et **en ce que** ledit modulateur d'impulsions en largeur (PM) peut être configuré afin de transformer ledit signal numérique modulé, suréchantillonné et converti vers le haut, à ladite fréquence d'échantillonnage de travail choisie et au moyen d'un nombre n choisi d'états en fonction d'une commande de contrôle reçue, en un signal RF analogique contenu dans ladite bande de fréquences de sortie choisie.

3. Dispositif selon l'une quelconque des revendications 1 et 2, **caractérisé en ce que** ladite bande de fréquences de sortie est inférieure ou égale à une bande de fréquences de sortie maximale associée à un nombre m minimal de bits de quantification, à un nombre n minimal d'états et à une fréquence d'échantillonnage de travail maximale.

4. Dispositif selon la revendication 3, **caractérisé en ce que** ladite bande de fréquences de sortie maximale est centrée sur une fréquence égale à 2,7 GHz, ledit nombre m minimal de bits de quantification est égal à 3, ledit nombre n minimal d'états est égal à 8, et ladite fréquence d'échantillonnage de travail maximale est égale à 10,8 GHz.

5. Dispositif selon l'une des revendications 1 à 4, **caractérisé en ce que** ledit moyen de transformation (TM) est conçu pour suréchantillonner ledit signal numérique multi-bits modulé en bande de base deux fois pour élaborer des échantillons RF numériques dudit signal numérique modulé, suréchantillonné et converti vers le haut.

6. Dispositif selon l'une des revendications 1 à 5, **caractérisé en ce qu'**il comprend en outre un moyen de suréchantillonnage (USi, USq) conçu pour suréchantillonner un signal numérique d'entrée reçu dix fois pour produire ledit signal numérique devant être modulé par ledit modulateur sigma-delta numérique (SM).

7. Dispositif selon l'une des revendications 1 à 6, **caractérisé en ce que** ledit moyen d'horloge (CM) comprend un oscillateur maître (MO) conçu pour produire un signal d'horloge principal à une fréquence principale, et un moyen de division (DM) configurable conçu pour diviser ladite fréquence principale du signal d'horloge par un nombre k en fonction de ladite commande de contrôle afin de définir ladite fréquence d'échantillonnage de travail choisie.

8. Dispositif selon la revendication 7, **caractérisé en ce que** ledit oscillateur maître (MO) peut être configuré pour produire un signal d'horloge principale à une fréquence principale choisie en fonction d'une commande de contrôle.

9. Dispositif selon la combinaison des revendications 6 et 8, **caractérisé en ce qu'**il comprend en outre un moyen de suréchantillonnage fractionnel (FUM) configurable conçu pour multiplier la fréquence d'échantillonnage d'un signal numérique primaire par un facteur fractionnel choisi en fonction d'une commande de contrôle afin de produire ledit signal numérique d'entrée à une fréquence compatible avec lesdites fréquences d'horloge du modulateur sigma-delta (SMi, SMq) et du modulateur d'impulsions en largeur (PM).

10. Dispositif selon la revendication 9, **caractérisé en ce qu'**il comprend en outre un oscillateur auxiliaire numérique (NO) configurable conçu pour produire un signal d'onde sinusoïdale complexe auxiliaire ayant une fréquence auxiliaire choisie qui dépend d'une commande de contrôle, et un moyen de combinaison (CBM) conçu pour combiner ledit signal auxiliaire avec un signal numérique brut afin de produire un signal numérique primaire qui est bien adapté à la configuration choisie dudit modulateur sigma-delta numérique (SM).

11. Amplificateur de puissance (PA), **caractérisé en ce qu'**il comprend un dispositif de génération de signaux de radiofréquence (GD) selon l'une des revendications 1 à 10 et un moyen d'amplification de puissance (PAM) conçu pour amplifier les signaux de radiofréquence analogiques produits par ledit dispositif de génération de signaux de radiofréquence (GD) pour produire des signaux analogiques amplifiés.

12. Procédé de génération de signaux de radiofréquence comprenant les étapes i) de modulation d'un signal numérique au moyen d'un modulateur sigma-delta numérique (SMi, SMq) pour délivrer en sortie un signal numérique modulé de m bits de quantification, et de suréchantillonnage et de conversion ascendante dudit signal numérique multi-bits modulé d'une bande de fréquences de base à une bande de radiofréquence à une fréquence d'échantillonnage de travail définie par un moyen d'horloge (CM), et ii) de transformation dudit signal numérique modulé, suréchantillonné et converti vers le haut, au moyen d'un modulateur d'impulsions en largeur (PM) et à ladite fréquence d'échantillonnage de travail et au moyen de n états, en un signal de radiofréquence analogique contenu dans une bande de fréquences de sortie, **caractérisé en ce que**, chaque fois que l'on souhaite utiliser une bande de fréquences de sortie choisie, il faut configurer ledit moyen d'horloge (CM), ledit modulateur sigma-delta numérique (SMi, SMq) et ledit modulateur d'impulsions en largeur (PM) au moyen de commandes de contrôle afin que ladite fréquence d'échantillonnage de travail varie d'une manière opposée audit nombre m de bits de quantification et audit nombre n d'états en fonction de ladite bande de fréquences de sortie choisie.

13. Procédé de transmission de signaux de radiofréquence analogiques à un équipement distant, **caractérisé en ce que** lesdits signaux de radiofréquence analogiques sont produits au moyen d'un dispositif de génération de signaux de radiofréquence (GD) selon l'une des revendications 1 à 10, ou au moyen d'un amplificateur de puissance (PA) selon la revendication 11, ou au moyen d'un procédé de génération de signaux de radiofréquence selon la revendication 12.
